# EUROPEAN PATENT APPLICATION

(11) **EP 4 293 369 A1**
(43) Date of publication of application: **20.12.2023**
(21) Application number: 22179435.7
(22) Date of filing: 16.06.2022
(51) Int. Cl.: G01R 31/327

(54) **SAFETY SWITCH DIAGNOSIS AND FAULT DETECTION**

(71) Applicant: Panasonic Industrial Devices Europe GmbH, 21337 Lueneburg (DE)
(72) Inventor: MASICH, Leon, 21337 Lüneburg (DE); MEYER, Andre, 21337 Lüneburg (DE); VÖLTZER, Jan, 21337 Lüneburg (DE); BOGDAN, Holger, 21337 Lüneburg (DE)
(74) Representative: Königer, Karsten

(57) **Abstract**

The present disclosure refers to systems (102, 103, 104, 105, 106, 107), devices, and corresponding methods for detecting a condition of a switching element (510) in a safety switch (500), including obtaining a signal indicative of an impedance of a safety switch (500) between an input port (712) and an output port (714) thereof, controlling the gate port (511) of the safety switch (500) to switch the switching element (510) between a closed state and an open state, comparing the impedance of the safety switch (500) in the closed state with the impedance of the safety switch (500) in the open state, and determining a condition of the switching element (510) based on the comparison.

## Description

### Field of the Disclosure

The present disclosure relates to methods, systems, and devices for detecting faulty conditions of safety switches in electronics circuitries.

### Technological Background

In recent years, electric power is being used more prevalently as the energy source for operating machines and vehicles for the transportation of goods and people. Such vehicles use electrically-powered motors to replace or complement internal combustion engines and come in various forms, including mild-hybrid vehicles, hybrid vehicles, plug-in hybrid vehicles, and fully electric vehicles.

Commonly, electrically powered vehicles include high-voltage circuitry and power sources, for powering high voltage loads, and low-voltage circuitry and power sources, for powering low voltage loads, in particular, low voltage circuitry and components commonly include a low voltage battery of the vehicle. Electric coupling of high-voltage circuitry and low-voltage circuitry is facilitated by utilizing an electric power converter, such as a DC-to-DC converter (DC/DC), which converts electric currents and from one voltage to another voltage.

A failure in the DC/DC converter, such as an electrical short in the DC/DC converter, could expose the low voltage circuitry to potential damage and consequently harm compromise of harm critical functions related to the operation of the vehicle. To mitigate this damage, safety switches are used between the DC/DC converter and the low-voltage circuitry, such that, in the case of a detected failure of the DC/DC converter, the safety switch is switched to an open state, thereby disconnecting the DC/DC from the low-voltage circuitry.

### Summary of Invention

The invention is defined by the appended claims. The description that follows is subjected to this limitation. Any disclosure lying outside the scope of said claims is only intended for illustrative as well as comparative purposes.

The safety switch is connected between the DC/DC converter and the low voltage circuitry to avoid or mitigate damage to the low voltage circuitry in case of a failure in the DC/DC converter.

Particularly, if a failure in the DC/DC converter is detected, the safety switch is controlled to switch to an open state for disconnecting the electrical connection between the low voltage circuitry and the DC/DC, thereby avoiding or mitigating potentially damaging effects for the low voltage circuitry resulting from the failure in the DC/DC converter, such as short currents through the DC/DC converter, which could lead to a short circuit of the low voltage battery of the vehicle.

To ensure this safety feature the safety switch must be functional when a failure in the DC/DC converter is detected, such that when a controller sets or controls the safety switch to be in an open state, the switch indeed switches to the open state to disconnect the DC/DC converter from the low voltage circuitry. A failure in the safety switch can result in a lack of ability to switch from a closed state, in which the DC/DC converter is electrically connected with the low-voltage circuit, to an open state, in which the DC/DC converter is electrically disconnected with the low-voltage circuit.

There is thus a need in the art for methods for diagnosing and detecting failures in safety switches during normal operation of the electronic circuitry.

According to aspects of the present disclosure, there is provided an electronic switching apparatus, including a safety switch and a controller. The safety switch includes a switching element including a source, a drain, and a gate configured to control an electrical connection between the source and the drain by facilitating an electrical connection between the source and the drain in a closed state of the switching element and terminating the electrical connection between the source and the drain in an open state of the switching element, and a diode element, electrically coupled in a parallel connection with the source and the drain of the switching element. The safety switch further includes an input port, connected to one of the source or the drain of the switching element, an output port, connected to another one of the source or the drain of the switching element different from the input port, and a gate port, connected to the gate of the switching element. The controller is electrically connected to the gate port of the safety switch, and the controller is configured to obtain a signal indicative of an impedance of the safety switch between the input port and output port thereof, control the gate port to switch the switching element between a closed state and an open state, compare the impedance of the safety switch in the closed state with the impedance of the safety switch in the open state, and determine a condition of the switching element based on the comparison. According to some embodiments, the safety switch includes, at least, two switches, as for example two MOSFETs (Metal Oxide Field Effect Transistors) connected in anti-series with shifted/opposite polarity, in order to achieve a bi-directional switch capable to block current in both directions. Additionally, each MOSFET Switch has its internal diode which is monodirectional and allows the passing of an electrical signal therethrough in one direction while blocking the passing of an electrical signal therethrough in an opposite direction. Furthermore, according to some embodiments, the safety switch is also connected to or includes a controller, connected to the gates of the aforementioned switches and capable of switching on and off the connection of anti-series/bi-directional switches separately and/or in combination.

In general, several configurations of anti-series switches are applicable, for example, it is possible to configure anti-series connection of switches in which several paralleled switches are connected having the same directionality, in parallel to several other paralleled switches having an opposite directionality, in order to decrease the overall losses in steady-state operation.

According to aspects of the present disclosure, there is provided a corresponding electronic system, including a high-voltage circuitry comprising a high-voltage power source, a low-voltage circuitry comprising a low-voltage power source, a power converter, configured to convert a high-voltage electric power signal from the high-voltage power source to a low-voltage electric power signal corresponding to the low-voltage circuitry, a safety switch, and a controller. Wherein the safety switch includes a switching element including a source, a drain, and a gate configured to control an electrical connection between the source and the drain by facilitating electrical connection between the source and the drain in a closed state of the switching element and terminating electrical connection between the source and the drain in an open state of the switching element, a diode element, electrically coupled in a parallel connection with the source and the drain of the switching element, an input port, connected to one of the source or the drain of the switching element, an output port, connected to another one of the source or the drain of the switching element different from the input port, and a gate port, connected to the gate of the switching element, wherein the input port of the safety switch is electrically connected to the power converter to obtain the low-voltage electric power signal and configured to controllably facilitate providing the low-voltage power signal to the low-voltage circuitry via the output port. The controller is electrically connected to the gate port of the safety switch and is configured to obtain a signal indicative of an impedance of the safety switch between the input port and output port thereof, control the gate port to switch the switching element between a closed state and an open state, compare the impedance of the safety switch in the closed state with the impedance of the safety switch in the open state, and determine a condition of the switching element based on the comparison. The impedance of the safety switch is indicative of the status of the safety switch.

While reference is made to DC to DC convertors between high-voltage circuitry and low voltage circuitry, it is understood that the disclosure is applicable to assemblies/circuitries including two low voltage circuitries, each operating at a different low voltage level, for example, 24 volt and 12 volt or 48 volt and 24 or 12 volt, or, alternatively, assemblies/circuitries including two low voltage circuitries, each operating at a different high voltage level, with a DC to DC convertor therebetween.

According to aspects of the present disclosure, there is provided a corresponding method for detecting a condition of a switching element in a safety switch, the method includes obtaining a signal indicative of an impedance of a safety switch between an input port and an output port thereof, controlling the gate port of the safety switch to switch the switching element between a closed state and an open state, comparing the impedance of the safety switch in the closed state with the impedance of the safety switch in the open state, and determining a condition of the switching element based on the comparison. As used herein, the signal indicative of an impedance of a safety switch is interchangeably used with a signal indicative of a voltage drop across the safety switch or a signal indicative of a status of the safety switch.

Advantageously, diagnosing and determining the condition of a safety switch during a normal operation of an electronic system mitigates the risk of having a failure of the safety switch when a disconnect is required between various sections of related circuitry.

Particularly, in a case where the switching element is not operable and remains in a closed state regardless of the control signal when a failure occurs in a connected circuitry, such as the DC/DC converter, if the switch is faulty, damage could occur to the low voltage circuitry without the ability to disconnect the low voltage circuitry from the DC/DC converter. Diagnosing and detecting a failure of the safety switch during normal operation is, therefore, advantageous in preventing such a scenario.

According to aspects of the present disclosure, determining a condition of the switching element includes determining that the switching element is defective when the difference between the impedance of the safety switch in the closed state and the impedance of the safety switch in the open state is below a predetermined fault-threshold, or determining that the switching element is functional when the difference between the impedance of the safety switch in the closed state and the impedance of the safety switch in the open state is above a predetermined functional-threshold.

According to aspects of the present disclosure, the controller is further configured to, and the method further includes the steps of repetitively controlling the gate port to switch the switching element between the closed state and the open state, perform comparisons of the impedance of the safety switch in a plurality of instances of a closed state with the impedance of the safety switch in a plurality of instances of an open state, and determine a condition of the switching element based on the comparisons

Advantageously, a reparative assessment of the changes in the impedance allows for identifying true cases of failure of the switching element and mitigating the effect of artifacts on the determination of the failure.

According to aspects of the present disclosure, determining a condition of the switching element based on the comparison includes detecting a defective instance of the switching element when the difference between the impedance of the safety switch in a closed state instance and the impedance of the safety switch in a time-adjacent open state instance is below a predetermined fault-threshold, and determining that the switching element is defective based on the number of defective instances detected within a predetermined time frame.

According to aspects of the present disclosure, the safety switch is a metal-oxide-semiconductor field-effect transistor, MOSFET, the switching element is a transistor element in the MOSFET, and the diode element is a diode characteristic of the MOSFET. As used herein, the expression "a diode characteristic of the MOSFET" is interchangeable with the term "body diode".

According to aspects of the present disclosure, the MOSFET is an enhanced type MOSFET. According to some embodiments, the MOSFET is a P-type MOSFET or an N-type MOSFET.

According to aspects of the present disclosure, the electronic switching apparatus and the electronic system further include at least one additional safety switch connected in parallel to the safety switch such that an input port of the additional safety switch is connected to the input port of the safety switch and an output port of the additional safety switch is connected to the output port of the safety switch, wherein the controller is further electrically connected to a gate port of the additional safety switch and is configured to obtain a signal indicative of an impedance of the additional safety switch, control the gate port of the additional safety switch to switch a switching element thereof between a closed state and an open state, and determine a condition of the switching element of the additional safety switch or the switching element of the safety switch based on comparing the impedance of the safety switch and the additional safety switch between the open state and closed state thereof.

According to aspects of the present disclosure, the method further includes the steps of, and the controller is further configured to, repetitively control the gate port to switch the switching element between the closed state and the open state, perform comparisons of the impedance of the safety switch in a plurality of instances of a closed state with the impedance of the safety switch in a plurality of instances of an open state, and determine a condition of the switching element based on the comparisons.

Advantageously, a parallel connection of multiple safety switches provides a reduction of impedance in the switching elements, and thereby reduces the power consumption of the safety switches.

Further aspects and embodiments of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1A and 1B: illustrate a schematic view of an electronic system with a DC to DC converter connecting high-voltage circuitry and low voltage circuitry.
- Fig. 2A, 2B, and 2C: schematically illustrate different states of an electronic system with a safety switch, according to another embodiment.
- Fig. 3: schematically illustrates an electronic system with multiple safety switches connected in parallel, according to another embodiment.
- Fig. 4: schematically illustrates an electronic system with a safety switch and a reverse direction safety switch, according to another embodiment.
- Fig. 5: schematically illustrates an electronic system with multiple safety switches connected in parallel and multiple reverse direction safety switches connected in parallel, according to another embodiment.
- Fig. 6: schematically illustrates an electronic system with a safety switch and an impedance measurement unit, according to another embodiment.
- Fig. 7a: schematically illustrates an electronic system with a safety switch and an implementation of an impedance measurement unit, according to another embodiment.
- Fig. 7b: schematically illustrates an electronic system with a safety switch and an implementation of an impedance measurement unit, according to another embodiment.
- Fig. 8: illustrates graphs of signals for assessing a condition of a safety switch, according to some embodiments.
- Fig. 9: illustrates a flow chart of a method for detecting a condition of a safety switch, according to some embodiments.
- Fig. 10: illustrates graphs of signals for assessing a condition of a safety switch, according to some embodiments.
- Fig. 11: schematically illustrates timelines for detecting a failure in a safety switch and performing a corresponding response process, according to some embodiments.
- Fig. 12: illustrates a flow chart of a method for detecting a condition of a safety switch, according to some embodiments.

### Detailed Description of the Invention

Reference will now be made in detail to embodiments, examples of which are illustrated in the accompanying drawings. Effects and features of the exemplary embodiments, and implementation methods thereof, will be described with reference to the accompanying drawings. In the drawings, like reference, numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," "approximately," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/-5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

As used herein, the terms "high voltage" and "low voltage" are relative terms relating to a relationship of am operational voltage level between two circuitries connected via a DC to DC convertor. For example, 24 volts can be referred to as "high voltage" when it is connected to a 12 volts circuitry which would be considered a "low voltage". In another example, 48 volts can be referred to as "high voltage" when it is connected to a 24 volts circuitry which would be considered a "low voltage".

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to one aspect of the present disclosure, an electronic and a corresponding electronic switching apparatus are provided, including a safety switch, and a controller, electrically connected to a gate port of the safety switch and configured to obtain a signal indicative of an impedance of safety switch between/across an input port and an output port thereof.

Particularly, the safety switch includes a switching element, including a source, a drain, and a gate. The gate is configured to control an electrical connection between the source and the drain, by facilitating an electrical connection between the source and the drain in a closed state of the switching element, and terminating the electrical connection between the source and the drain in an open state of the switching element.

The safety switch further includes a diode element, electrically coupled in a parallel connection with the source and the drain of the switching element.

The connection ports of the safety switch include: an input port, connected to one of the source or the drain of the switching element, an output port, connected to another one of the source or the drain of the switching element different from the input port, and a gate port, connected to the gate of the switching element.

When the safety switch is in operation, the controller is configured to control the gate port to switch the switching element between a closed state and an open state, compare the impedance of the safety switch in the closed state with the impedance of the safety switch in the open state, and determine a condition of the switching element based on the comparison.

According to a corresponding aspect of the present disclosure, a method for detecting a condition of a switching element in a safety switch is provided. The method includes the steps of obtaining a signal indicative of an impedance of a safety switch between an input port and an output port thereof, controlling the gate port of the safety switch to switch the switching element between a closed state and an open state, and comparing the impedance of the safety switch in the closed state with the impedance of the safety switch in the open state. The method proceeds by determining a condition of the switching element based on the comparison.

As used herein, the term impedance is interchangeable with the term resistance.

In an embodiment, the safety switch is a directional safety switch, configured to facilitate the passing of an operational current/signal in one direction regardless to whether the switching element is in an open or closed state, and when the current is a reverse current, in an opposite direction to the operational current, the safety switch is configured to facilitate the passing of the current if the switching element is in a closed state and to block the passing of the current of the reverse current if the switching element is in an open state.

More specifically, when the direction of the current passing through the safety switch is an operational direction, the current is permitted to pass through the switching element and the diode element of the safety switch, such that, when the switch is in an open state, an operational current is permitted to pass through the diode element, and when the switch is in a closed state, an operational current is permitted to pass through the diode element and the switching element.

In some embodiments, at least two safety switches are connected in series with an opposite polarity, such that each switch is configured to control the passage of current in one direction and by controlling both switches to be disconnected, current passage is interrupted regardless to the directionality of the current, since each of the safety switches interrupts the passage of current on one direction opposite to the other safety switch.

Under normal operation, when operational current passes through the safety switch, preferably, the switching element is in a closed state, facilitating the passing of the operational current through the safety switch with a reduced impedance relative to a state when the switching element is in an open state and the current is permitted to pass through the diode element only.

Differences in the impedance of the safety switch between an open state and a closed state thereof, while an operational current passes therethrough, advantageously, indicate whether the switching element is functional or faulty.

Particularly, if no change or minor change of impedance is detected affected by the change of state of the switching element, this indicates that the switching element is not operable properly for blocking the passage of currents therethrough. Alternatively, if the change of state of the switching element results in a change of impedance of the safety switch, particularly an increase of impedance, this indicates that the switching element is functioning properly by blocking the passage of currents therethrough.

In a functional state of the safety switch, when the switching element is in a closed state, the impedance of the safety switch would be that of a parallel connection of a diode and a closed state switching element, and when the switching element is in an open state, the impedance of the safety switch would be that of a diode alone, which is greater than the impedance of the diode in parallel connection to a switching element in a closed state. On the other hand, in a faulty state of the safety switch, for example, when the switching element is always in a connected/closed state without the ability to controllably disconnect the source and the drain, the impedance of the safety switch would be that of a parallel connection of a diode and a closed switching element when the switching element is controlled to be in a closed state and also when it is controlled to be in an open state, as the connection between the source and the drain would be maintained, at least to some extent, regardless to the gate control signal.

Advantageously, switching the switching element between an open state and a closed state during a normal operation of the safety switch allows the operational current to pass from the high voltage circuitry and the low voltage circuitry without major disruptions, by imposing relatively minor changes to the impedance through which the connection is maintained, thereby facilitating the ability to diagnose and detect failures in the switching element without disrupting the operation of the connected circuitry.

According to some embodiments, the changes in the impedance of the safety switch are assessed by obtaining a signal indicative of an impedance of the safety switch. The signal indicative of an impedance of the safety switch could include, for example, a measurement of a potential drop across the switching element.

According to some embodiments, controlling the gate port to switch the switching element between a closed state and an open state, for comparing the impedance of the safety switch in the closed state with the impedance of the safety switch in the open state, comprises a closed state phase, in which the gate port is controlled to switch the switching element to a closed state, and an open state phase, in which the gate port is controlled to switch the switching element to an open state.

As used herein, a closed state phase and an adjacent open state phase form a sampling cycle or a sample. The duration of the sample is determined by adding the duration of the closed state phase and the adjacent open state phase. The sampling frequency is determined by the number of sample cycles within a period of time, for example, the number of sample cycles within one second. A duty cycle of the sample is determined based on the ratio between an open phase duration and the duration of the sample cycle.

According to some embodiments, the open phase duration is less than the closed state duration, within a sampling cycle, resulting in a duty cycle of less than 50%. According to some embodiments, the duty cycle is less than 5%. According to some embodiments, the duty cycle is less than 1%. According to some embodiments, the duty cycle is approximately 0.1%.

According to some embodiments, the duration of a sampling cycle is less than 100ms. According to some embodiments, the duration of a sampling cycle is less than 20ms. According to some embodiments, the duration of a sampling cycle is approximately 10ms.

According to some embodiments, the duration of the open phase is less than 1ms. According to some embodiments, the duration of the open phase is less than 100us. According to some embodiments, the duration of the open phase is approximately 10us.

According to one embodiment, the duration of the sampling cycle is approximately 10ms and the duration of the open phase is approximately 10us.

An operation of the low-voltage circuitry can include switching and changes of electrical characteristics of various components therein, these changes could affect the signal indicative of the impedance of the safety switch and result in artifacts therein. These artifacts, when timed close to the evaluation of the safety switch, could result in a misdiagnosis of the safety switch condition.

To mitigate the effect of the low-voltage circuitry artifacts on the determination of the condition of the switching element, according to some embodiments, determining a condition of the switching element includes determining that the switching element is defective when the difference between the impedance of the safety switch in the closed state and the impedance of the safety switch in the open state is below a predetermined fault-threshold, and/or determining that the switching element is functional when the difference between the impedance of the safety switch in the closed state and the impedance of the safety switch in the open state is above a predetermined functional-threshold.

To further mitigate this effect of low-voltage circuitry artifacts on the determination of the condition of the switching element, the assessment of the changes in the impedance of the safety switch is performed multiple times, and based on the multiple assessments of the impedance changes while switching the states of the switching element, a condition of the switching element is determined.

Particularly, according to some embodiments, the controller is further configured to repetitively control the gate port to switch the switching element between the closed state and the open state, perform comparisons the impedance of the safety switch in a plurality of instances of a closed state with the impedance of the safety switch in a plurality of instances of an open state, and determine a condition of the switching element based on the comparisons.

According to some embodiments, a confidence score of a proper/functional condition of the safety switch or switching element is derived based on the multiple/repetitive comparisons of the impedance of the safety switch in instances of open state and closed state of the switching element. According to some embodiments, when the confidence score of a proper condition of the safety switch falls below a certain threshold, the condition of the safety switch is determined to be faulty.

According to some embodiments, determining a condition of the switching element based on the comparison includes detecting a defective instance of the switching element when the difference between the impedance of the safety switch in a closed state instance and the impedance of the safety switch in a time-adjacent open state instance is below a predetermined fault-threshold, and determining that the switching element is defective based on the number of defective instances detected within a predetermined time frame.

Advantageously, repetitively assessing the condition of the switching element at a certain frequency allows detecting a defective condition of the switching element in a timely manner and mitigates the risk of a short in the DC/DC converter occurring while the switching element is faulty.

On the one hand, performing multiple comparisons of the impedance reduces misdiagnoses of the condition of the safety switch affected by the artifacts from the low-voltage circuitry. On the other hand, timely detection of a faulty condition of the switching element is required, so that response action, such as a shut-off procedure or proper notifications, could take place in a timely manner, for example within a certain time frame from the moment when a fault occurs in the safety element.

Advantageously, defining a predetermined time frame, within which multiple comparisons/assessments are performed, mitigates the risk of misdiagnosis and allows for a timely response to a failure of the safety element. According to some embodiments, the rate/frequency of assessments and corresponding control of the gate port is determined based on the number of assessments desired within the predetermined time frame for detecting a fault in the condition of the safety switch.

According to some embodiments, a moving window of the most recent samples/assessments is considered for determining the condition of the switching element. According to some embodiments, when the number of samples/assessments indicating faulty conditions within the moving window is equal to or exceeding a predetermined threshold, a faulty condition of a safety switch is determined. The number of samples/assessments within a moving window is determined based on the duration of the moving window and the sampling/assessment frequency. According to some embodiments, the moving window includes 10 assessments, and when the number of fault assessments within the moving window is 5 or more, a faulty condition of a safety switch is determined.

According to some embodiments, a counter for faulty assessments is included, wherein each fault functioning assessment increments the counter and each proper functioning assessment decrements the counter, such that, when the counter reaches a certain predetermined number/count, a fault condition of a safety switch is determined. According to some embodiments, the predetermined number/count for determining a fault condition of a safety switch is in the range of 2 to 10. In some embodiments, the predetermined number/count for determining a fault condition of a safety switch is in the range of 5 to 8. In some embodiments, the predetermined number/count for determining a fault condition of a safety switch is in 7.

According to some embodiments, the safety switch is a metal-oxide-semiconductor field-effect transistor, MOSFET, the switching element is a transistor element in the MOSFET, and the diode element is a diode characteristic of the MOSFET. According to come embodiments, the MOSFET is a P-Type MOSFET. According to some embodiments, the MOSFET is an N-TYPE MOSFET. According to some embodiments, the MOSFET is an Enhanced MOSFET.

According to some embodiments, at least one additional safety switch is used, and is connected in parallel to the safety switch such that an input port of the additional safety switch is connected to the input port of the safety switch and an output port of the additional safety switch is connected to the output port of the safety switch, wherein the controller is further electrically connected to a gate port of the additional safety switch and is configured to obtain a signal indicative of an impedance of the additional safety switch, control the gate port of the additional safety switch to switch a switching element thereof between a closed state and an open state, and determine a condition of the switching element of the additional safety switch or the switching element of the safety switch based on comparing the impedance of the safety switch and the additional safety switch between the open state and closed state thereof.

Advantageously, connecting multiple safety switches in a parallel connection reduces the overall impedance of the safety switching assembly, thereby reducing the power consumption thereof.

The plurality of safety switches can be considered as multiple components in one safety switch or in one safety switching assembly.

When a plurality of safety switches is used, an assessment of each of the switching elements therein is desirable. However, due to the parallel connection of the safety switches, in some settings, an assessment of the impedance of each of the safety switches independently might not be attainable. Thus, the signal indicative of an impedance of a safety switch, according to some embodiments, is a signal indicative of all the safety switches connected in a parallel connection. In such embodiments, the detection of a faulty state in a safety switch is indicative of a fault of one or more of the used safety switches, however, since one faulty safety switch could comprise the proper functioning of the entire safety switching assembly, due to the parallel connection of the safety switches, a detection of a fault in any one of more of the switching elements is sufficient for initiating a response procedure, such as a turning off the system or providing a notification.

According to some embodiments, when the malfunctioning of the safety switch is detected by means of the impedance comparison, the DCDC stops delivering power and a shut-down of all system supplies is conducted, mitigating the possibility of internal damage that could lead to a short circuit in the low voltage battery which could occur due to the lack of the ability to open the safety switch.

According to some embodiments, the time from a failure of a switching element to the ending of the response procedure is less than 200ms. According to some embodiments, the time from a failure of a switching element to the ending of the response procedure is approximately 100ms. According to some embodiments, a duration of a response procedure is deducted from the time from a failure of a switching element to the ending of the response to establish a time frame for detecting a faulty condition of the switching element. According to some embodiments, when the time from a failure of a switching element to the ending of the response procedure is approximately 100ms and the duration of a response procedure is 30ms, a time frame for detecting a faulty condition of the switching element is 70ms.

According to some embodiments, the comparison of the impedance and evaluation of the safety switch is performed every 10 ms. Then, this comparison is assessed as correct/functioning or not correct/faulty by the microcontroller. When that a comparison is considered as wrong/faulty, a counter is increased and when the comparison is considered to be correct/functioning, this counter is decreased. According to some embodiments, if the counter reaches a predetermined threshold, for example a value of 7, then the DCDC stops delivering power and optionally system shuts-down because it is corroborated that the safety switch is damaged. Then, in this specific case, the system will stop to deliver current, for example after 7 consecutive faulty evaluations, after 70 ms.

### Specific Embodiments

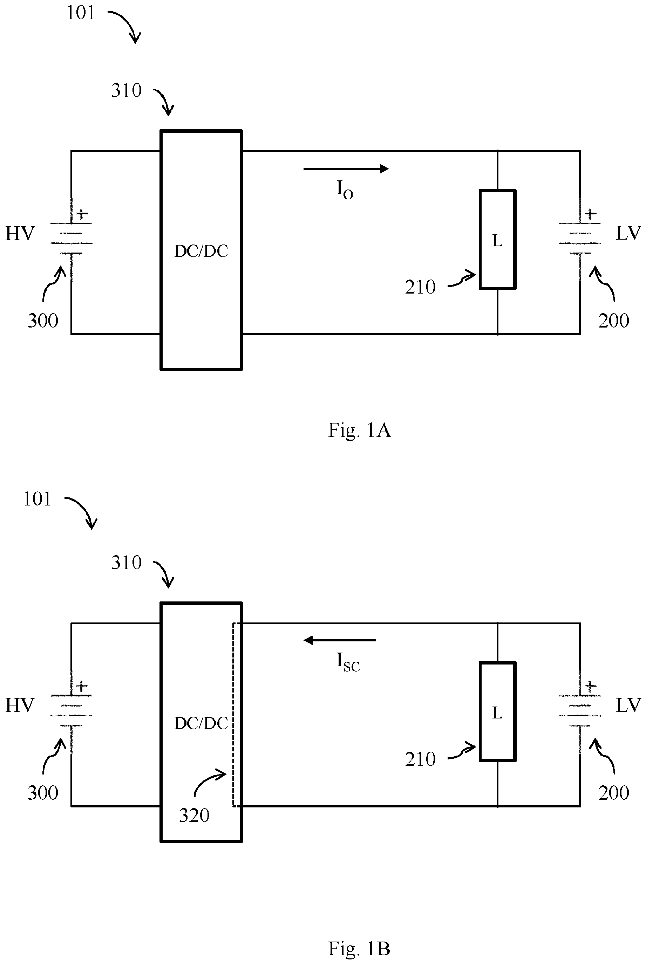

Reference is now made to Fig. 1A and Fig. 1B, which illustrate a schematic view of an electronic system 101 with a DC-to-DC converter 310 connecting high-voltage circuitry and low voltage circuitry. As illustrated, the high voltage circuitry includes a high voltage power source, such as high voltage battery 300, and the low voltage circuitry includes a low voltage power source, such as low voltage battery 200, and a low voltage load 210.

The low voltage load 210 can include various components in an electrical vehicle, such as control systems, infotainment systems, sensors, low voltage battery, and the like.

Commonly, the high voltage battery 300 is more powerful, both in voltage and charge capacity, than the low voltage battery 200. To facilitate the transfer of electrical power from the high voltage battery 300 to the low voltage circuitry, a DC to DC converter 310 is used, for transforming the high voltage power signal from the high voltage battery 300, to a low voltage signal, corresponding to the voltage of the low voltage battery 200 and load 210.

As used herein, the term low voltage may refer to voltage in the range of 3 to 30 volts. Specifically, the term low voltage commonly refers to a voltage of approximately 12 volts.

As used herein, the term high voltage may refer to voltage in a range above 30 volts.

Referring to Fig. 1A, during normal operation, an operation current, lo, is provided from the high voltage battery 300, through the DC/DC converter 310, to the low voltage circuitry.

The direction of the operational current lo is intended to be from the DC/DC converter 310 to the low voltage circuitry, as denoted by the arrow "lo".

Referring to Fig. 1B, when a short circuit 320 occurs in the DC/DC converter 310, sort circuit currents, Isc, could pass from the low voltage circuitry into the DC/DC converter 310, in a direction opposite to the operational current I_{O}. The short-circuit currents can drain the low voltage battery 200 rapidly and can damage components in the low voltage circuitry, such as the low voltage load 210.

To mitigate the risk imposed by the short circuit current, a safety switch is placed between the DC/DC converter 310 and the low voltage circuitry. The safety switch is operated such that, when a short circuit, or another defective operation is detected in the DC/DC converter, the safety switch terminates/cuts-off the electrical connection between the DC/DC converter 310 and the low voltage circuitry.

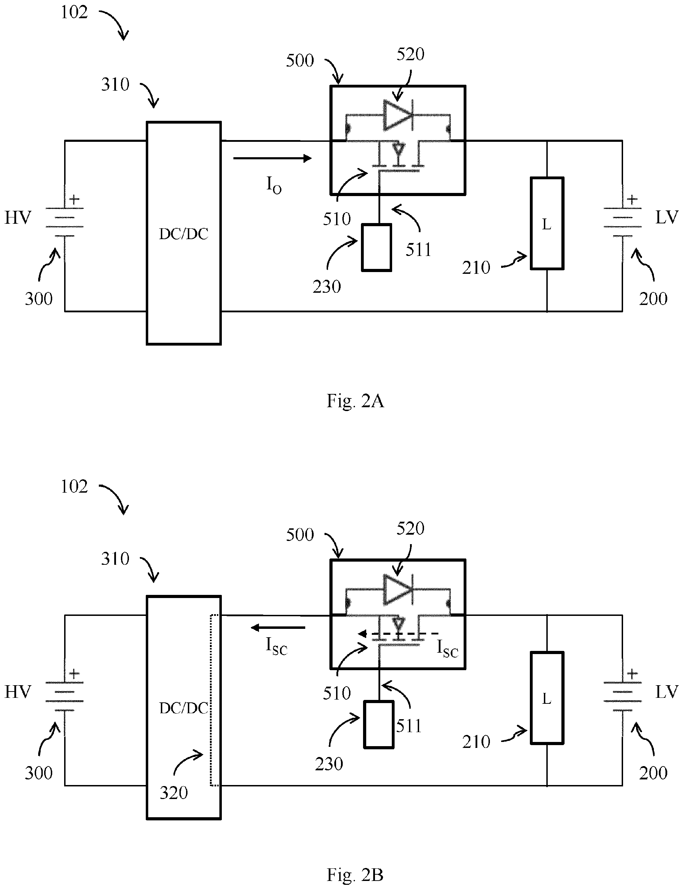

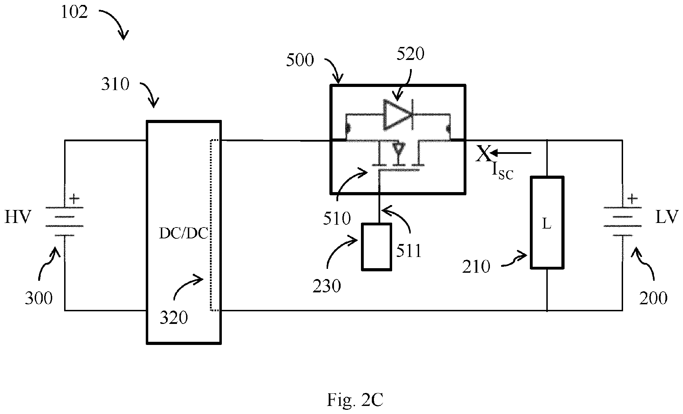

Reference is now made to Fig. 2A, Fig. 2B, and Fig. 2C, which schematically illustrate different states of an electronic system 102 with a safety switch 500, according to another embodiment.

Referring to Fig. 2A, the safety switch 500 is positioned to control the electrical connection between the DC/DC converter 310 and the low voltage circuitry. The safety switch 300 is directional, in that it permits the passing of signals/current therethrough in one direction, corresponding to the direction of the operational current, I_{O}, and controllably terminates the passing of signals/currents therethrough in an opposite direction, such as a direction of a short circuit current, I_{SC}.

This functionality is accomplished as the safety switch 500 includes a diode element 520 connected in parallel to a switching element 510. The parallel nature of the electrical connection between the diode element 520 and the switching element 510 results in that signals/current passing through the safety switch in an operational direction, I_{O}, are permitted either via the switching element 510 and the diode element 520, when the switching element 510 is in a closed state, or through the diode element 520 alone, when the switching element 510 is in an open state.

Referring to Fig. 2B and Fig. 2C, When the current passing through the safety switch is in a direction opposite to the operational direction, the diode element 520 does not facilitate the passing of current therethrough, and the switching element 510 can controllably facilitate or terminate the passing of the current therethrough based on the state of the switching element 510: when the switching element 510 is in a closed state, passing of current therethrough is facilitated, and when the switching element 510 in an open state, passing of current therethrough is not facilitated.

In Fig. 2B the control signal is provided to the gate port 511 by the controller 230 to set the switching element 510 in a closed state, permitting the short circuit current I_{SC} to pass through the switching element 510.

In Fig. 2C, once a short circuit 320 is detected in the DC/DC converter 310, the control signal is provided to the gate port 511 by the controller 230 to set the switching element 510 in an open state, thereby disconnecting the DC/DC converter 310 from the low voltage circuitry and terminating the short circuit current Isc.

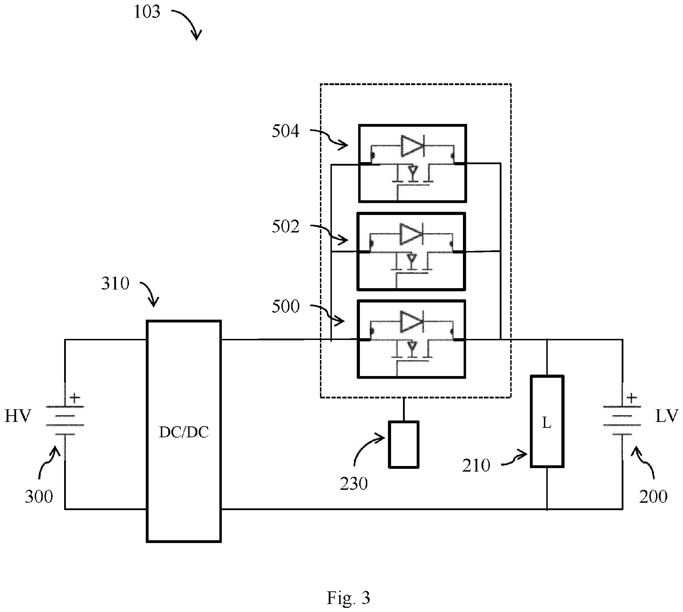

Various configurations of safety switches or safety switching assemblies are provided in Fig. 3, Fig. 4, and Fig. 5.

Reference is now made to Fig. 3, which schematically illustrates an electronic system 103 with multiple safety switches connected in parallel, according to another embodiment. Instead of placing only one safety switch 500 between the DC/DC converter 310 and the low voltage circuitry, multiple safety switches can be connected in parallel to reduce the overall impedance of the safety switching assembly. Particularly, the safety switch 500 is connected in parallel with a second safety switch 502 and a third safety switch 506, thereby resulting in an impedance equivalent to a third of the impedance obtained when using only one safety switch 500. The reduction of the impedance is advantageous in reducing the load on each of the safety switches, as well as in reducing the power consumption of the safety switching assembly.

The parallel connection between the safety switch 500, the second safety switch 502, and the third safety switch 504, is attained by electrically connecting the input ports of the safety switches together, and electrically connecting the output ports of the safety switches together.

In some embodiments, the control signal for controlling the state of the switching elements of the safety switch 500, the second safety switch 502, and the third safety switch 504, is provided individually by the controller 230, to facilitate individual control over each of the safety switches.

Alternatively, the same control signal is provided in some embodiments to the safety switch 500, the second safety switch 502, and the third safety switch 504, facilitating a simplified control scheme, wherein all the switches are controlled together using one control signal provided by the controller 230.

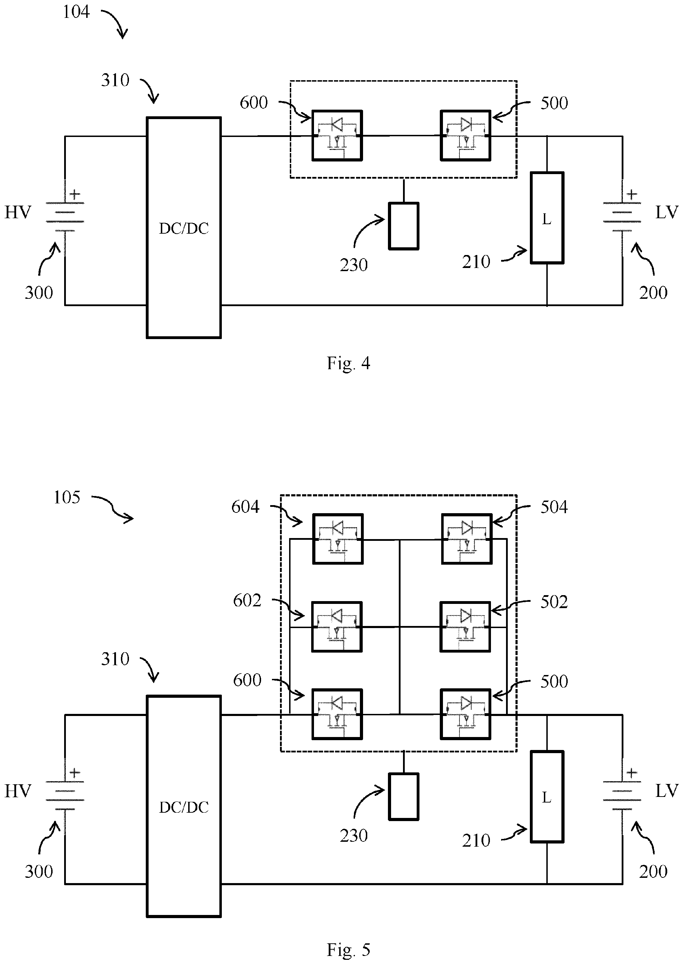

Reference is now made to Fig. 4, which schematically illustrates an electronic system 104 with a safety switch 500 and a reverse safety switch 600, according to another embodiment. The nature of the safety switch 500, as discussed above, is directional, meaning that the safety switch 500 is configured to controllably disconnect current in one direction, which is a direction reverse to a direction of a normal operational current.

Preferably, the controller 230 provides independent control signals to the safety switch 500 and the reverse safety switch, thereby facilitating selecting switching to specific current directions.

To controllably connect and disconnect the flow of current in the operational direction, a reverse safety switch 600 is used. The reverse safety switch 600 is connected serially to the safety switch 500, along the electric path between the DC/DC converter 310 and the low voltage circuitry. In some embodiments, the safety switch 500 and the reverse safety switch form a safety switch assembly.

Reference is now made to Fig. 5, which schematically illustrates an electronic system 105 with multiple safety switches connected in parallel to one another, and multiple reverse direction safety switches connected in parallel to one another, according to another embodiment.

To reduce the load on each of the switches, for example by reducing the amount of current passing therethrough, and/or for reducing the overall impedance of the safety switching assembly, a second safety switch 502 and a third safety switch 504 are connected in parallel to the safety switch 500. Additionally, a second reverse safety switch 602 and a third reverse safety switch 604 are connected in parallel to the reverse safety switch 600.

According to some embodiments, an impedance measuring unit is provided for evaluating/measuring the impedance of the safety switch at different points in time and under different conditions.

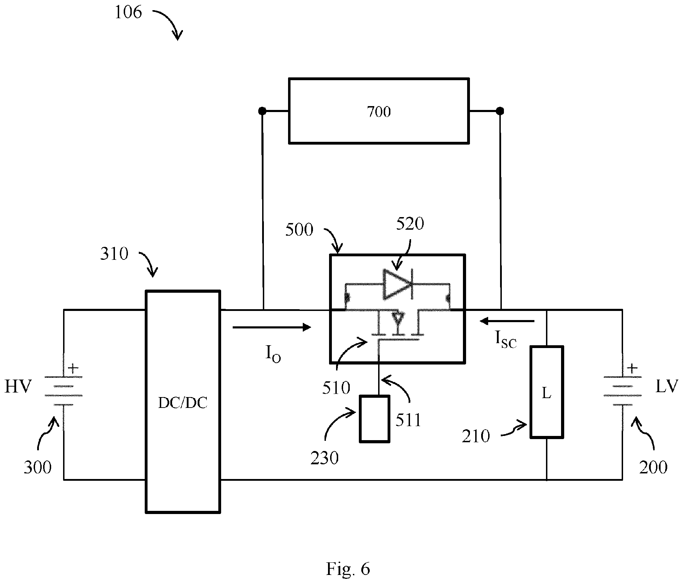

Reference is now made to Fig. 6, which schematically illustrates an electronic system 106 with a safety switch 500 and an impedance measurement unit 700, according to another embodiment.

The configuration of an impedance measurement unit 700 connected to measure the impedance of safety switch 500 is applicable to various configurations of safety switches, particularly as brought in electronic systems 103, 104, and 105.

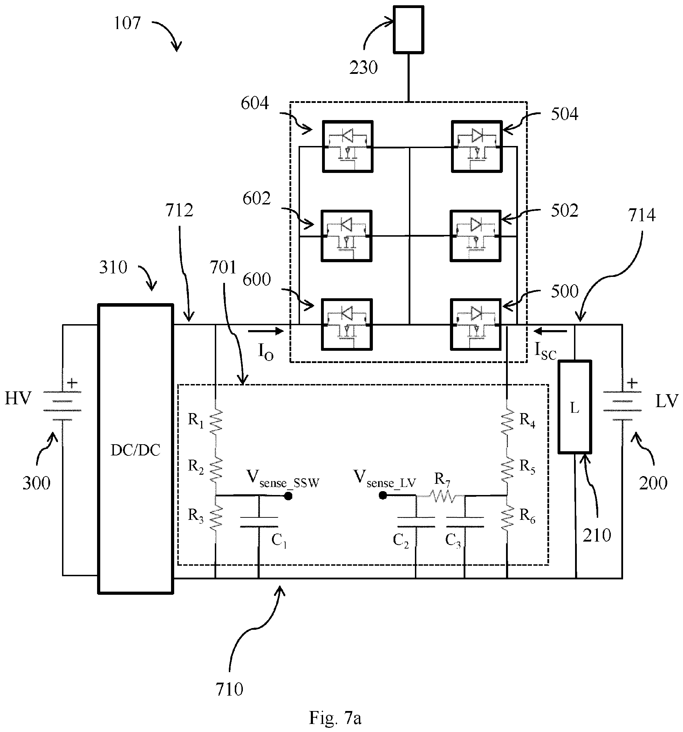

As brought in figure 7a, the impedance measurement unit 700 is configured to provide to the controller 230 a signal indicative of the impedance of the safety switch 500. In a preferable embodiment, the signal indicative of the impedance of the safety switch 500 is a measurement of a potential/voltage drip across the safety switch 500, such as, given no or minor changes in other components in the electronic system 106, an increase in the impedance of the safety switch 500 would result in an increased potential drop across the safety switch 500, and on the other hand, a decrease in the impedance of the safety switch 500, would result in a decreased potential drop across the safety switch 500.

In a practical example, when the safety switch is closed, representing an ON state, the impedance to measure is that of a paralleled connection of internal diode and internal resistance. In this case the value expected from the impedance generated by this parallel connection is lower than the minor of the two impedances. When the safety switch is opened, representing an OFF state, the expected measurement of the impedance is the voltage drop of the diode, which is bigger than the expected parallel impedance. If the result of this measurement corresponds to the impedance of a parallel connection of the diode and the MOSFET, this results in an assessment that the safety switch is damaged/faulty, because the switch is not able to change to an open state.

A specific implementation of the impedance measurement unit 700 is brought in Fig. 7a.

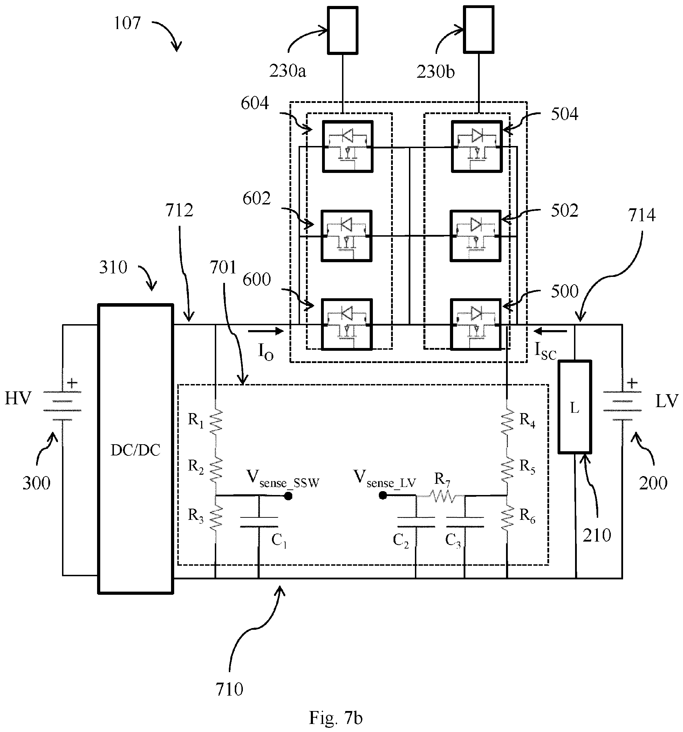

Reference is now made to Fig. 7a and Fig. 7b, which schematically illustrates an electronic system 107 with safety switches 500, 502, and 504, reverse safety switches 600, 602, and 604, and an implementation of an impedance measurement unit 701, according to another embodiment.

The impedance measurement unit 701 is connected for measuring the potential drop across the safety switches 500, 502, and 504, and the reverse safety switches 600, 602, and 604.

Resistors R₁, R₂, and R₃ are connected serially between the input of the safety switches 712, which is the output of the DC/DC converter 310, and the common line 710, or ground line.

Resistors R₄, R₅, and R₆ are connected serially between the output of the safety switches 716, which is the input of the low voltage circuitry, and the common line 710.

As brought in figure 7b, the impedance measurement unit 700 is configured to provide to either one or both of two controllers 230a and 230b a signal indicative of the impedance of the safety switch 500. In a preferable embodiment, the signal indicative of the impedance of the safety switch 500 is a measurement of a potential/voltage drip across the safety switch 500, such as, given no or minor changes in other components in the electronic system 106, an increase in the impedance of the safety switch 500 would result in an increased potential drop across the safety switch 500, and on the other hand, a decrease in the impedance of the safety switch 500, would result in a decreased potential drop across the safety switch 500. Particularly, referring to figure 7b, each of the controllers 230a and 230b is configured to control the state of reverse safety switches 600, 602, and 604 or safety switches 500, 502, and 504, respectively.

According to some embodiments, in other words, under normal operation a switch controller may switch on all the safety switch components, including safety switches and reverse safety switches, such as MOSFETs, 600, 602, 604, 500, 502 and 504. In such a case, a current can flow through the parallelized MOSFETs in anti-series connection, resulting in a current flowing from the DCDC to the LV battery and loads and represented as lo in Fig.6, Fig.7a and Fig. 7b. In other scenarios, when under normal operation a failure occurs in the DCDC converter, the current changes its direction, flowing from the LV battery terminal to the DCDC through the safety switch. This reverse current is depicted in Fig. 6, Fig.7 and Fig. 7b as Isc. When this event occurs, the safety switch must be opened by means of the controller 230 or controllers 230a and 230b that turns off the safety switch, resulting in avoiding the current flowing from the LV battery to the DCDC, thereby preventing a short circuit in the LV battery.

Vsense_ssw is measured as the potential drop on R₃, and V_{sense_LV} is measured as the potential drop on R₆. Vsense_ssw is indicative of the potential at the input of the safety switches 712, and V_{sense_LV} is indicative of the potential at the output of the safety switches 714. The difference between Vsense_ssw and V_{sense_LV}, is indicative of the potential drop across the safety switches, which is affected by the impedance thereof.

Specifically, Vsense_ssw and V_{sense_LV} are provided to circuitry configured to generate a signal in the low voltage range, such as 0v to 5v, based on the difference between Vsense_ssw and V_{sense_LV}. In an embodiment, Vsense_ssw and V_{sense_LV} are provided to a comparator-amplifier circuitry, or a substraction and amplification circuitry, which generates a signal, such as a pulse signal in the range of 0v to 5v.

Capacitors C₁, C₂, and C₃ and resistor R₇ are configured to reduce the measurement noise of Vsense_ssw and V_{sense_LV}. Various other implementations of circuitry for reducing noise on potential measurements are applicable.

In a particular implementation, resistors R₁, R₂, R₃, R₄, R₅, and R₆ each have a resistance of 2.7KOhm, resistor R₇ has a resistance of 33Ohm, and capacitors C₁, C₂, and C₃ each have a capacitance of 3.3nF.

For example, when the DC/DC converter 310 provides a 250Amp signal to the low voltage circuitry, in normal operation, with a maximal resistance of each of the safety switches being 1.15mOhm, each safety switch would have a voltage drop of 125mv, and the safety switches setting as a whole, including the safety switches 500, 502, and 504, and the reverse safety switches 600, 602, and 604, would result in a voltage drop of 250mv.

In a normal/functional condition of the safety switches 500, 502, and 504, changing the gate control signal to switch the switching elements to an open state, would result in an increased impedance of the safety switches, and as a result, the voltage drop across the safety switches is expected to increase, under the previous example of providing 250A by the DC/DC converter 310, to approximately 0.9v.

In a faulty condition, minor or no changes to the voltage drop are expected.

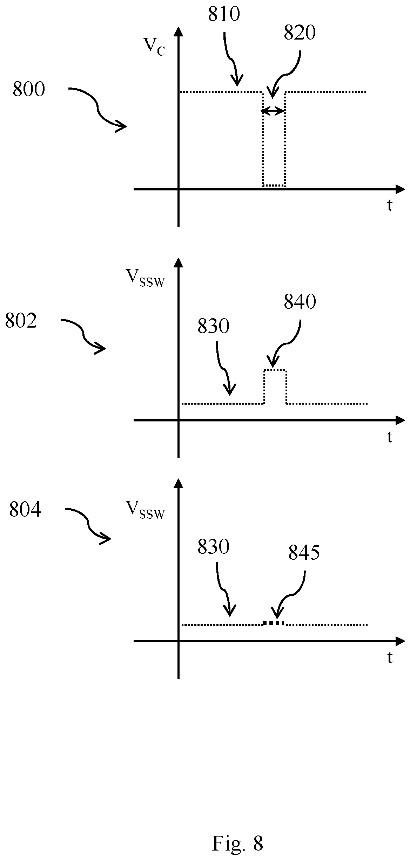

Reference is now made to Fig. 8, which illustrates graphs of signals for assessing a condition of a safety switch, according to some embodiments.

When the controlled provides a control signal Vc 800 to switch the switching element from a closed state 810 to an open state 820, in a normal condition 802 of the safety switch, the voltage drop across the safety switch Vssw is expected to change from a reference level 830 to an increased level 840 as a result of the proper switching of the switching element.

In a faulty condition 804 of the safety switch, when the controlled provides a control signal Vc 800 to switch the switching element from a closed state 810 to an open state 820, the voltage drop across the safety switch Vssw remains unchanged 845 compared to the reference level 830, as the switching element is not able to establish an open state.

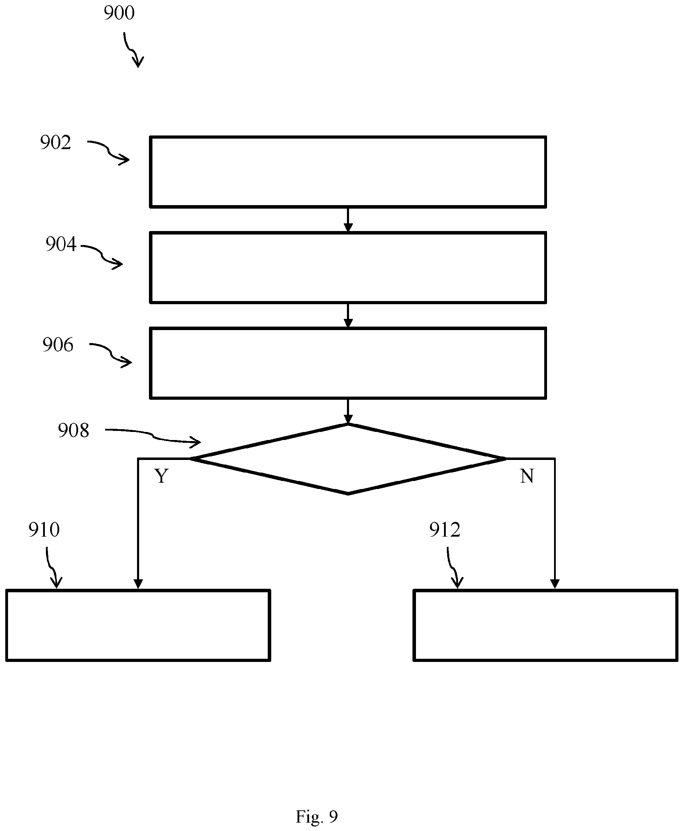

Reference is now made to Fig. 9, which illustrates a flow chart of a method 900 for detecting a condition of a safety switch, according to some embodiments. The method for diagnosing the condition of the safety switch is applicable, while the safety switch is operating in circuitry for providing signals from a DC/DC converter to low voltage circuitry 902. During the normal operation, the controller provides a control signal to switch the switching elements of the safety switch from a closed state to an open state 904, and the controller obtains measurements indicating changes in the impedance of the safety switch before and after the switching control 906. If the impedance is changed above a certain threshold due to the switching, it is determined that the condition of the safety switch is functional 910, and if the impedance does not change above a certain threshold due to the switching, it is determined that the condition of the safety switch is faulty 912.

As the measurement indicative of the impedance of the safety switch could be affected by various factors, including changes and switches in the low voltage circuitry, or changes in the signal current from the DC/DC converter, determining the condition of the safety switch based on a single sample/assessment might not be accurate.

To overcome this problem, the controller is configured, according to some embodiments, to perform multiple, repetitive, samples/assessments of the condition of the safety switch, and to determine the condition of the safety switch based on the result of the multiple samples.

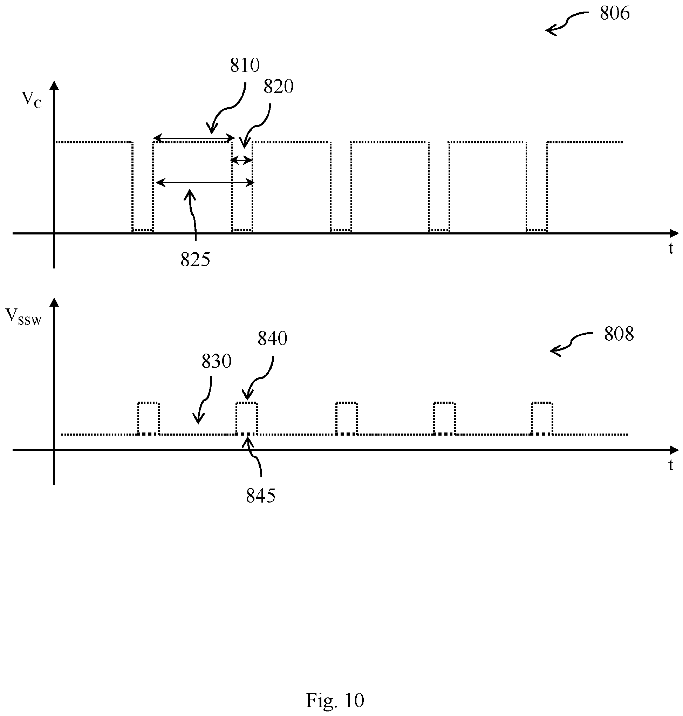

Reference is now made to Fig. 10, which illustrates graphs of signals for assessing a condition of a safety switch, according to some embodiments. The controller provides a control signal 806 for controlling the switching element to switch between a closed state 810 and an open state 820 every period of time, which is referred to as the sampling rate 825. Correspondently, the controller measures the potential drop across the safety switch 808 to assess changes thereof from a baseline 830 determined prior to the switching from the closed state to the open state, to a sample state, in which the voltage drop would remain substantially unchanged 845 if the switch is faulty or changed to an increased level 840 if the switch if functional.

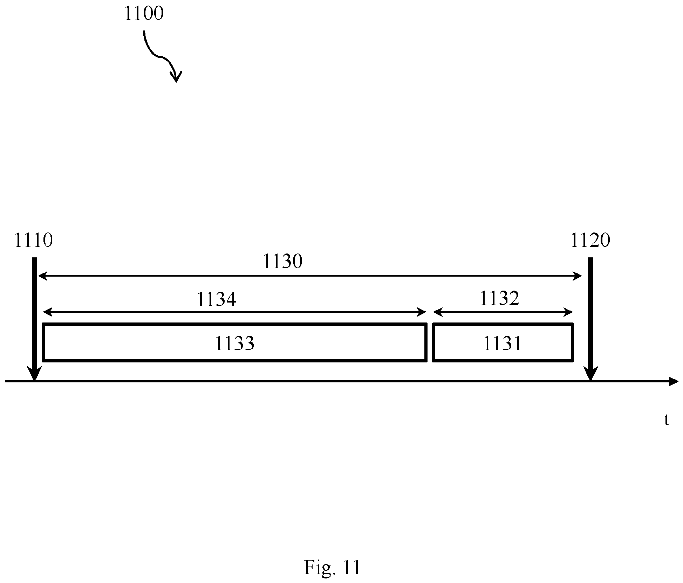

Reference is now made to Fig. 11, which schematically illustrates timelines 1100 for detecting a failure in a safety switch 1133 and performing a corresponding response process 1131, according to some embodiments. To assure the safety of the electric circuitry, a response to a failure in the safety switch needs to be completed within a certain time limit 1130, to mitigate the risk of a short circuit occurring to the DC/EC converter while the safety switch is faulty. A response process 1131, such as a shutdown of the system, takes a certain amount of time 1132, which establishes the time for detecting a failure 1134.

As a result, the multiple samples, or one sample, for determining the condition of the safety switch can occur within that time window for detecting a failure 1134.

In a specific example, if the response to a failure in the safety switch needs to be completed within a certain time limit 1130 of 100ms and the shutdown procedure 1132 takes 30ms, the time for detecting a fault in the safety switch is 70ms.

As a result, if 7 samples are required for achieving high confidence in determining a failure of the safety switch, the time is between samples is 10ms, resulting in a sampling rate of 100 samples per second.

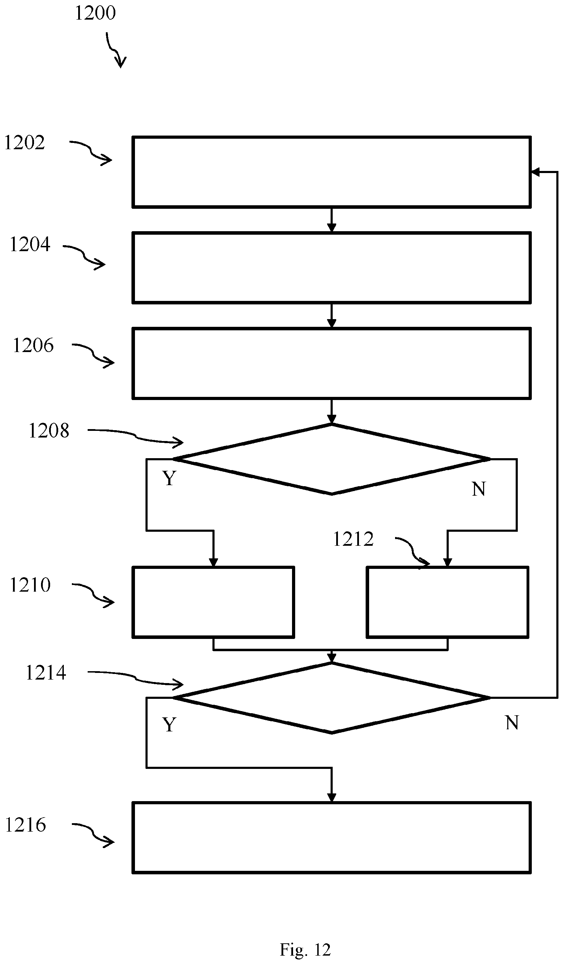

Fig. 12 illustrates a flow chart of a method 1200 for detecting a condition of a safety switch, according to some embodiments. Particularly, the method 1200 for diagnosing the condition of the safety switch is applicable while the safety switch is operating in circuitry for providing signals from a DC/DC converter to low voltage circuitry 1202. During the normal operation, the controller provides a control signal to switch the switching elements of the safety switch from a closed state to an open state 1204, and the controller obtains measurements indicating changes of the impedance of the safety switch before and after the switching control 1206. If the impedance is changed above a certain threshold due to the switching 1208-Y, it is determined that the condition of the safety switch is functional and a fault counter is decreased 1210. Alternatively, if the impedance does not change above a certain threshold due to the switching 1208-N, a fault counter is increased 1212. If the fault counter is below a certain number 1214-N, for example below 7, another sample is initiated 1202, and if the fault counter is equal to a certain number 1214-Y, a response operation, such as a shutdown is initiated 1216.

### Reference signs

- 101 to 107: electronic system
- 200: low voltage battery
- 210: low voltage load
- 230, 230a, 230b: controller
- 300: high voltage battery
- 310: DC/DC, DC to DC converter
- 320: short-circuit
- 500, 502, 504: safety switch, SSW
- 510: switching element, transistor element
- 511: gate port
- 520: diode element
- 600, 602, 604: reverse safety switch
- 700, 701: impedance measuring unit
- 710: common line, ground line
- 712: input of the safety switches
- 714: output of the safety switches
- 800, 806: control signal
- 802, 804, 808: potential on safety switch graph
- 810: closed state
- 820: open state
- 830, 840, 845: potential on the safety switch
- 900, 1200: method for diagnosing safety switch
- 1100: timeline for diagnosing and reacting to failure
- 1131: response process
- 1132: shutdown time frame
- 1133: failure detection operation
- 1134: failure detection time frame

## Claims

1. An electronic switching apparatus, comprising
a safety switch (500), comprising
a switching element (510) including a source, a drain, and a gate configured to control an electrical connection between the source and the drain by facilitating an electrical connection between the source and the drain in a closed state of the switching element and terminating the electrical connection between the source and the drain in an open state of the switching element,
a diode element (520), electrically coupled in a parallel connection with the source and the drain of the switching element,
an input port, connected to one of the source or the drain of the switching element,
an output port, connected to another one of the source or the drain of the switching element different from the input port, and
a gate port (511), connected to the gate of the switching element, and
a controller (230), electrically connected to the gate port of the safety switch, wherein the controller is configured to:
obtain a signal indicative of an impedance of the safety switch between the input port and output port thereof,
control the gate port to switch the switching element between a closed state and an open state,
compare the impedance of the safety switch in the closed state with the impedance of the safety switch in the open state, and
determine a condition of the switching element based on the comparison.

2. The electronic switching apparatus of claim 1, wherein determining a condition of the switching element comprises:
determining that the switching element is defective when the difference between the impedance of the safety switch in the closed state and the impedance of the safety switch in the open state is below a predetermined fault threshold, or
determining that the switching element is functional when the difference between the impedance of the safety switch in the closed state and the impedance of the safety switch in the open state is above a predetermined functional threshold.

3. The electronic switching apparatus of claim 1, wherein the controller is further configured to:
repetitively control the gate port to switch the switching element between the closed state and the open state,
perform comparisons of the impedance of the safety switch in a plurality of instances of a closed state with the impedance of the safety switch in a plurality of instances of an open state, and
determine a condition of the switching element based on the comparisons.

4. The electronic switching apparatus of claim 3, wherein determining a condition of the switching element based on the comparison comprises:
detect a defective instance of the switching element when the difference between the impedance of the safety switch in a closed state instance and the impedance of the safety switch in a time-adjacent open state instance is below a predetermined fault-threshold, and
determining that the switching element is defective based on the number of defective instances detected within a predetermined time frame.

5. The electronic switching apparatus of claims 1 to 4, wherein the safety switch is a metal-oxide-semiconductor field-effect transistor, MOSFET, the switching element is a transistor element in the MOSFET, and the diode element is a diode characteristic of the MOSFET.

6. The electronic switching apparatus of claims 1 to 5, further comprising at least one additional safety switch (502, 504) connected in parallel to the safety switch such that an input port of the additional safety switch is connected to the input port of the safety switch and an output port of the additional safety switch is connected to the output port of the safety switch,
wherein the controller is further electrically connected to a gate port of the additional safety switch and is configured to obtain a signal indicative of an impedance of the additional safety switch, control the gate port of the additional safety switch to switch a switching element thereof between a closed state and an open state, and determine a condition of the switching element of the additional safety switch or the switching element of the safety switch based on comparing the impedance of the safety switch and the additional safety switch between the open state and closed state thereof.

7. An electronic system (102, 103, 104, 105, 106, 107), comprising:
a high-voltage circuitry comprising a high-voltage power source;
a low-voltage circuitry comprising a low-voltage power source;
a power converter (310), configured to convert a high-voltage electric power signal from the high-voltage power source to a low-voltage electric power signal corresponding to the low-voltage circuitry;
a safety switch (500), comprising
a switching element (510) including a source, a drain, and a gate configured to control an electrical connection between the source and the drain by facilitating an electrical connection between the source and the drain in a closed state of the switching element and terminating the electrical connection between the source and the drain in an open state of the switching element,
a diode element (520), electrically coupled in a parallel connection with the source and the drain of the switching element,
an input port, connected to one of the source or the drain of the switching element,
an output port, connected to another one of the source or the drain of the switching element different from the input port, and
a gate port (511), connected to the gate of the switching element,
wherein the input port of the safety switch is electrically connected to the power converter to obtain the low-voltage electric power signal and configured to controllably facilitate providing the low-voltage power signal to the low-voltage circuitry via the output port; and
a controller (230), electrically connected to the gate port of the safety switch, wherein the controller is configured to:
obtain a signal indicative of an impedance of the safety switch between the input port and output port thereof,
control the gate port to switch the switching element between a closed state and an open state,
compare the impedance of the safety switch in the closed state with the impedance of the safety switch in the open state, and
determine a condition of the switching element based on the comparison.

8. The electronic system of claim 7, wherein determining a condition of the switching element comprises:
determining that the switching element is defective when the difference between the impedance of the safety switch in the closed state and the impedance of the safety switch in the open state is below a predetermined fault threshold, or
determining that the switching element is functional when the difference between the impedance of the safety switch in the closed state and the impedance of the safety switch in the open state is above a predetermined functional threshold.

9. The electronic system of claim 7, wherein the controller is further configured to:
repetitively control the gate port to switch the switching element between the closed state and the open state,
perform comparisons of the impedance of the safety switch in a plurality of instances of a closed state with the impedance of the safety switch in a plurality of instances of an open state, and
determine a condition of the switching element based on the comparisons.

10. The electronic system of claim 9, wherein determining a condition of the switching element based on the comparison comprises:
detect a defective instance of the switching element when the difference between the impedance of the safety switch in a closed state instance and the impedance of the safety switch in a time-adjacent open state instance is below a predetermined fault-threshold, and
determining that the switching element is defective based on the number of defective instances detected within a predetermined time frame.

11. The electronic system of claims 7 to 10, wherein the safety switch is a metal-oxide-semiconductor field-effect transistor, MOSFET, the switching element is a transistor element in the MOSFET, and the diode element is a diode characteristic of the MOSFET.

12. A method for detecting a condition of a switching element in a safety switch, the method comprising:
obtaining a signal indicative of an impedance of a safety switch between an input port and an output port thereof,
controlling the gate port of the safety switch to switch the switching element between a closed state and an open state,
comparing the impedance of the safety switch in the closed state with the impedance of the safety switch in the open state, and
determining a condition of the switching element based on the comparison.

13. The method of claim 12, wherein determining a condition of the switching element comprises:
determining that the switching element is defective when the difference between the impedance of the safety switch in the closed state and the impedance of the safety switch in the open state is below a predetermined fault threshold, or
determining that the switching element is functional when the difference between the impedance of the safety switch in the closed state and the impedance of the safety switch in the open state is above a predetermined functional threshold.

14. The method of claim 12, further comprising:
repetitively controlling the gate port to switch the switching element between the closed state and the open state,
performing comparisons of the impedance of the safety switch in a plurality of instances of a closed state with the impedance of the safety switch in a plurality of instances of an open state, and
determining a condition of the switching element based on the comparisons.

15. The method of claim 14, wherein determining a condition of the switching element based on the comparison comprises:
detecting a defective instance of the switching element when the difference between the impedance of the safety switch in a closed state instance and the impedance of the safety switch in a time-adjacent open state instance is below a predetermined fault-threshold, and
determining that the switching element is defective based on the number of defective instances detected within a predetermined time frame.

## Amended claims

### Amended claims in accordance with Rule 137(2) EPC.

1. An electronic switching apparatus, comprising
a safety switch (500), comprising
a switching element (510) including a source, a drain, and a gate configured to control an electrical connection between the source and the drain by facilitating an electrical connection between the source and the drain in a closed state of the switching element and terminating the electrical connection between the source and the drain in an open state of the switching element,
a diode element (520), electrically coupled in a parallel connection with the source and the drain of the switching element,
an input port, connected to one of the source or the drain of the switching element,
an output port, connected to another one of the source or the drain of the switching element different from the input port, and
a gate port (511), connected to the gate of the switching element, and
a controller (230), electrically connected to the gate port of the safety switch, wherein the controller is configured to:
obtain a signal indicative of an impedance of the safety switch between the input port and output port thereof,
control the gate port to switch the switching element between a closed state and an open state,
compare the impedance of the safety switch in the closed state with the impedance of the safety switch in the open state, and
determine a condition of the switching element based on the comparison
**characterized in that** the controller is further configured to:
repetitively control the gate port to switch the switching element between the closed state and the open state,
perform comparisons of the impedance of the safety switch in a plurality of instances of a closed state with the impedance of the safety switch in a plurality of instances of an open state, and
determine a condition of the switching element based on the comparisons.

2. The electronic switching apparatus of claim 1, wherein determining a condition of the switching element comprises:
determining that the switching element is defective when the difference between the impedance of the safety switch in the closed state and the impedance of the safety switch in the open state is below a predetermined fault threshold, or
determining that the switching element is functional when the difference between the impedance of the safety switch in the closed state and the impedance of the safety switch in the open state is above a predetermined functional threshold.

3. The electronic switching apparatus of claim 1, wherein determining a condition of the switching element based on the comparison comprises:
detect a defective instance of the switching element when the difference between the impedance of the safety switch in a closed state instance and the impedance of the safety switch in a time-adjacent open state instance is below a predetermined fault-threshold, and
determining that the switching element is defective based on the number of defective instances detected within a predetermined time frame.

4. The electronic switching apparatus of claims 1 to 3, wherein the safety switch is a metal-oxide-semiconductor field-effect transistor, MOSFET, the switching element is a transistor element in the MOSFET, and the diode element is a diode characteristic of the MOSFET.

5. The electronic switching apparatus of claims 1 to 4, further comprising at least one additional safety switch (502, 504) connected in parallel to the safety switch such that an input port of the additional safety switch is connected to the input port of the safety switch and an output port of the additional safety switch is connected to the output port of the safety switch,
wherein the controller is further electrically connected to a gate port of the additional safety switch and is configured to obtain a signal indicative of an impedance of the additional safety switch, control the gate port of the additional safety switch to switch a switching element thereof between a closed state and an open state, and determine a condition of the switching element of the additional safety switch or the switching element of the safety switch based on comparing the impedance of the safety switch and the additional safety switch between the open state and closed state thereof.

6. An electronic system (102, 103, 104, 105, 106, 107), comprising:
a high-voltage circuitry comprising a high-voltage power source;
a low-voltage circuitry comprising a low-voltage power source;
a power converter (310), configured to convert a high-voltage electric power signal from the high-voltage power source to a low-voltage electric power signal corresponding to the low-voltage circuitry;
a safety switch (500), comprising
a switching element (510) including a source, a drain, and a gate configured to control an electrical connection between the source and the drain by facilitating an electrical connection between the source and the drain in a closed state of the switching element and terminating the electrical connection between the source and the drain in an open state of the switching element,
a diode element (520), electrically coupled in a parallel connection with the source and the drain of the switching element,
an input port, connected to one of the source or the drain of the switching element,
an output port, connected to another one of the source or the drain of the switching element different from the input port, and
a gate port (511), connected to the gate of the switching element,
wherein the input port of the safety switch is electrically connected to the power converter to obtain the low-voltage electric power signal and configured to controllably facilitate providing the low-voltage power signal to the low-voltage circuitry via the output port; and
a controller (230), electrically connected to the gate port of the safety switch,
wherein the controller is configured to:
obtain a signal indicative of an impedance of the safety switch between the input port and output port thereof,
control the gate port to switch the switching element between a closed state and an open state,
compare the impedance of the safety switch in the closed state with the impedance of the safety switch in the open state, and
determine a condition of the switching element based on the comparison,
**characterized in that** the controller is further configured to:
repetitively control the gate port to switch the switching element between the closed state and the open state,
perform comparisons of the impedance of the safety switch in a plurality of instances of a closed state with the impedance of the safety switch in a plurality of instances of an open state, and
determine a condition of the switching element based on the comparisons.

7. The electronic system of claim 6, wherein determining a condition of the switching element comprises:
determining that the switching element is defective when the difference between the impedance of the safety switch in the closed state and the impedance of the safety switch in the open state is below a predetermined fault threshold, or
determining that the switching element is functional when the difference between the impedance of the safety switch in the closed state and the impedance of the safety switch in the open state is above a predetermined functional threshold.

8. The electronic system of claim 6, wherein determining a condition of the switching element based on the comparison comprises:
detect a defective instance of the switching element when the difference between the impedance of the safety switch in a closed state instance and the impedance of the safety switch in a time-adjacent open state instance is below a predetermined fault-threshold, and
determining that the switching element is defective based on the number of defective instances detected within a predetermined time frame.

9. The electronic system of claims 6 to 8, wherein the safety switch is a metal-oxide-semiconductor field-effect transistor, MOSFET, the switching element is a transistor element in the MOSFET, and the diode element is a diode characteristic of the MOSFET.

10. A method for detecting a condition of a switching element in a safety switch, the method comprising:
obtaining a signal indicative of an impedance of a safety switch between an input port and an output port thereof,
controlling the gate port of the safety switch to switch the switching element between a closed state and an open state,
comparing the impedance of the safety switch in the closed state with the impedance of the safety switch in the open state, and
determining a condition of the switching element based on the comparison,
**characterized in that** the method further comprises:
repetitively controlling the gate port to switch the switching element between the closed state and the open state,
performing comparisons of the impedance of the safety switch in a plurality of instances of a closed state with the impedance of the safety switch in a plurality of instances of an open state, and
determining a condition of the switching element based on the comparisons.

11. The method of claim 10, wherein determining a condition of the switching element comprises:
determining that the switching element is defective when the difference between the impedance of the safety switch in the closed state and the impedance of the safety switch in the open state is below a predetermined fault threshold, or
determining that the switching element is functional when the difference between the impedance of the safety switch in the closed state and the impedance of the safety switch in the open state is above a predetermined functional threshold.

12. The method of claim 10, wherein determining a condition of the switching element based on the comparison comprises:
detecting a defective instance of the switching element when the difference between the impedance of the safety switch in a closed state instance and the impedance of the safety switch in a time-adjacent open state instance is below a predetermined fault-threshold, and
determining that the switching element is defective based on the number of defective instances detected within a predetermined time frame.
